# FASCICULE DE BREVET EUROPEEN

(11) **EP 3 939 073 B1**
(45) Date de publication et mention de la délivrance du brevet: **11.10.2023**
(21) Numéro de dépôt: 20713950.2
(22) Date de dépôt: 26.02.2020
(51) Int. Cl.: H01L 21/67

(54) **DISPOSITIF DE MAINTIEN POUR UN ENSEMBLE À FRACTURER**
HALTEVORRICHTUNG FÜR EIN ZU BRECHENDES AGGREGAT
HOLDING DEVICE FOR AN ASSEMBLY THAT IS TO BE FRACTURED

(30) Priorité: 15.03.2019 FR 1902681
(43) Date de publication de la demande: 19.01.2022
(73) Titulaire: SOITEC, 38190 Bernin (FR)
(72) Inventeur: LANDRU, Didier, 38190 LE CHAMP-PRES-FROGES (FR); KONONCHUK, Oleg, 38570 THEYS (FR); BEN MOHAMED, Nadia, 38130 ECHIROLLES (FR)
(74) Mandataire: IP Trust
(86) Numéro de dépôt international: PCT/FR2020/050371
(87) Numéro de publication internationale: WO 2020/188171

(56) Documents cités:
- FR-A1- 2 995 441
- US-A1- 2012 261 076
- US-A1- 2013 105 538

## Description

### Domaine technique

La présente invention concerne de manière générale le traitement des matériaux, et plus particulièrement de substrats pour l'électronique, l'optique ou l'optoélectronique. Plus précisément, l'invention concerne un dispositif de maintien d'un ensemble à fracturer destiné à se séparer le long d'un plan de fracture entre une partie supérieure et une partie inférieure de l'ensemble à fracturer.

### État de la technique antérieure

Un procédé connu de fabrication de substrats SOI (acronyme de l'expression anglo-saxonne « Silicon On Insulator » pour Silicium sur isolant), appelé procédé Smart Cut^{™}, comprend principalement les étapes suivantes :
- une étape d'implantation ionique d'espèces légères, à une profondeur donnée dans un substrat donneur, pour former un plan fragile enterré comprenant des microcavités et délimitant une couche superficielle destinée à être transférée sur un substrat support ; le substrat donneur est par exemple constitué de silicium monocristallin ;
- une étape d'assemblage de ce substrat donneur sur un substrat support tel que du silicium, éventuellement oxydé en surface, l'ensemble formant un ensemble à fracturer ;
- une étape de fracture pour séparer l'ensemble à fracturer selon le plan fragile enterré, en une première partie comprenant le substrat support et la couche superficielle transférée (le substrat SOI), et en une deuxième partie comprenant le reste du substrat donneur.

Au cours de cette dernière étape, un traitement thermique de fragilisation peut favoriser la coalescence et la mise sous pression des microcavités présentes dans le plan fragile enterré. Sous l'effet de ce traitement thermique seul, ou par l'intermédiaire d'efforts additionnels appliqués après le traitement thermique, l'initiation et la propagation d'une onde de fracture le long du plan fragile enterré permet de séparer l'ensemble à fracturer en deux parties.

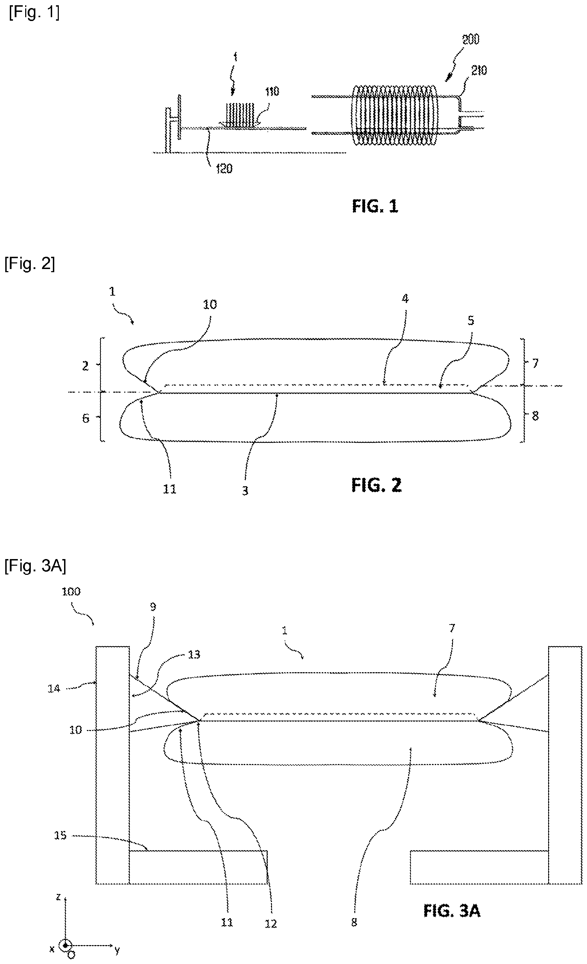

Cette dernière étape est classiquement mise en oeuvre dans des fours de recuit dont la configuration horizontale est illustrée sur la figure 1. De tels fours sont conçus pour traiter simultanément une pluralité d'ensembles à fracturer dans un tube en quartz 210.

La figure 1 montre ainsi une pluralité d'ensembles à fracturer 1 disposés sur un réceptacle 110 tel qu'une nacelle en quartz, les ensembles à fracturer étant alignés parallèlement les uns aux autres. La nacelle 110 est elle-même placée sur une pelle 120 mobile, permettant de charger les ensembles à fracturer 1 dans le tube 210 du four et de les décharger en fin de recuit.

Comme on le voit sur la figure 1, les ensembles à fracturer 1 sont disposés verticalement, c'est-à-dire que le plan de fracture pour chacun des ensembles à fracturer 1 est vertical.

En raison de la disposition verticale des ensembles à fracturer 1, les deux parties après fracture restent dans la pratique très proches l'une de l'autre, voire plaquées l'une contre l'autre. La préhension de chacune des parties doit alors être conduite avec les plus grandes précautions, pour assurer un éloignement des deux parties sans détérioration de leurs états de surface, par frottement notamment. Plusieurs méthodes ont été développées pour réaliser cette manipulation. On peut notamment citer les documents EP 1 124 674 ou EP 1 423 244.

Le document EP 1 331 663 présente une alternative aux fours de recuit horizontaux. Dans ce document, les ensembles à fracturer ne sont pas disposés verticalement mais horizontalement. Ce document décrit également la possibilité de manipuler les ensembles à fracturer avant et après séparation au moyen d'un robot de manutention.

Le document US 2013/0105538 présente également un équipement dans lequel les ensembles à fracturer sont disposés horizontalement, maintenus par des pinces et retenus par des bras et des disques horizontaux susceptibles d'être actionnés.

La Demanderesse a constaté que lorsqu'un ensemble à fracturer est positionné horizontalement, le glissement d'une partie par rapport à l'autre au cours de la fracture et/ou l'étape de préhension de chacune des parties issues de la séparation pouvaient générer des rayures sur les faces en regard des deux parties, du fait d'un possible mouvement relatif et frottement d'une partie sur l'autre. Ceci est particulièrement vrai si l'assemblage repose sur un support rigide. Apres séparation, le substrat se trouvant en haut va se rapprocher sous l'effet de son poids du substrat du bas. Plus la distance séparant les deux substrats sera faible, plus la probabilité de contact (et donc d'endommagement) sera élevée.

On connaît du document EP 1 385 683 un dispositif et un procédé de coupe permettant de séparer avec une haute précision les deux parties issues de la fracture d'un ensemble à fracturer. Un tel procédé consiste à poser l'ensemble à fracturer horizontalement sur un châssis fixe et plan, le châssis supportant également une cale et un support de déplacement d'une lame fixée sur ce support de déplacement. La surface latérale de l'ensemble à fracturer est amenée en butée contre la cale, la lame étant destinée à initier, dans le plan de fracture, la séparation de l'ensemble à fracturer.

Des dispositifs et procédés similaires sont présentés dans les documents FR 2 995 441 et US 2012/0261076.

Toutefois, ce document ne traite pas la question du devenir des parties issues de l'ensemble à fracturer une fois la séparation réalisée. Un tel dispositif peut en effet comporter une difficulté à maintenir chaque partie à distance l'une de l'autre, notamment pour pouvoir procéder à leur préhension, leur manipulation et leur déplacement sans risque d'endommagement ou de contamination.

### Exposé de l'invention

Un but de l'invention est de résoudre au moins en partie les inconvénients exposés ci-dessus en proposant un dispositif permettant une intervention minimale pour éloigner les deux parties d'un ensemble à fracturer horizontal, après fracture, et une manipulation aisée desdites parties, limitant ainsi les risques d'endommagement ou de contamination.

En vue de la réalisation de ce but, l'objet de l'invention propose un dispositif de maintien d'un ensemble à fracturer selon la revendication 1

Un tel dispositif permet de séparer les deux parties de l'ensemble à fracturer et de les maintenir distantes l'une de l'autre sans avoir à recourir à une quelconque manipulation extérieure, manipulation susceptible d'endommager ou de contaminer l'une ou l'autre des parties. La séparation est assurée par la seule action de la gravité sur le substrat inférieur.

Un tel dispositif présente en outre l'avantage de n'exercer aucun contact avec les faces en regard l'une de l'autre de chacune des parties de l'ensemble à fracturer. Un contact ou une contrainte exercé sur une face de l'ensemble à fracturer est susceptible de dégrader la qualité de la fracture et par conséquent, de diminuer l'uniformité des couches transférées. Un dispositif conforme à l'invention présente donc l'avantage de fournir des substrats présentant une homogénéité de surface importante.

Selon d'autres caractéristiques avantageuses et non limitatives de l'invention, prises seules ou selon toute combinaison techniquement réalisable :
- les ergots sont disposés sur des colonnes ;
- au moins un ergot est disposé sur une colonne amovible apte à être déplacée pour placer l'ensemble à fracturer dans la position de maintien ;
- le dispositif de maintien comprend au moins trois ergots ;
- le dispositif de maintien comprend également des moyens d'initiation d'une onde de fracture pour initier, dans le plan de fracture, la séparation de l'ensemble à fracturer ;
- les moyens d'initiation comprennent une lame ;
- les moyens d'initiation comprennent un appareil à ultrasons apte à émettre une onde ultrasonore ;
- le support est destiné à recevoir la partie inférieure au niveau d'une face arrière de la partie inférieure et comprend un évidement pour permettre la préhension de la partie inférieure par sa face arrière ;

L'objet de l'invention concerne également un équipement de séparation pour séparer un ensemble à fracturer, l'équipement de séparation comprenant une enceinte et, disposé dans l'enceinte, un dispositif de maintien conforme à ce qui a été exposé ci-dessus.

Selon d'autres caractéristiques avantageuses et non limitatives de l'invention, prises seules ou selon toute combinaison techniquement réalisable :
- l'enceinte est une chambre d'un four pour réaliser un traitement thermique de l'ensemble à fracturer et pour fragiliser le plan de fracture ;
- le four comprend des moyens de chauffage par convection, par rayonnement IR ou micro-ondes, par induction ;
- le four est un four monoplaque à recuit rapide.

### Description des figures

D'autres avantages et particularités de l'invention apparaîtront à la lecture de la description détaillée de mises en oeuvre et de modes de réalisation nullement limitatifs, au regard de dessins annexés sur lesquels :
[Fig. 1] La figure 1 représente un four de recuit de l'état de la technique ;
[Fig. 2] La figure 2 représente une vue en coupe d'un ensemble à fracturer ;
[Fig. 3A] La figure 3A représente une vue latérale, en coupe d'un dispositif de maintien conforme à l'invention avant séparation de l'ensemble à fracturer ;
[Fig. 3B] La figure 3B représente une vue de dessus d'un dispositif de maintien conforme à l'invention ;
[Fig. 3C] La figure 3C représente une vue latérale, en coupe d'un dispositif de maintien conforme à l'invention après séparation de l'ensemble à fracturer.

### Description de mode de réalisation

Dans la description qui suit, des descriptions détaillées de fonctions et d'éléments connus, qui pourraient inutilement rendre obscur l'essentiel de la présente invention, seront omises.

Les figures sont des représentations schématiques qui, dans un objectif de lisibilité, ne sont pas nécessairement à l'échelle. En particulier, les épaisseurs des couches ne sont pas à l'échelle par rapport aux dimensions latérales de ces couches, ni par rapport aux dimensions des éléments composant un dispositif de maintien conforme à la présente invention.

La présente invention porte sur un dispositif de maintien pour un ensemble à fracturer 1. La structure d'un tel ensemble à fracturer 1 est schématiquement représentée sur la figure 2.

Classiquement, un ensemble à fracturer 1 est mis en oeuvre dans le procédé Smart Cut^{™}, comme rappelé en introduction.

Dans ce procédé, une étape d'implantation ionique d'espèces légères, telles que par exemple des ions d'hydrogène et/ou d'hélium, est réalisée dans un substrat donneur 2, au niveau d'une face principale 3. Le substrat donneur 2 peut être constitué de silicium monocristallin, ou de tout autre matériau d'intérêt.

De façon connue en soi, et comme cela est représenté sur la figure 2, les ions implantés ont pour but de former une zone fragile enterrée 4 que nous nommerons par la suite « plan de fracture 4 » ; ce plan de fracture 4 délimite d'une part, une couche mince 5 située du côté de la face principale 3 et d'autre part, le reste du substrat donneur 2, appelé négatif.

Dans une étape suivante d'assemblage, également bien connue, on assemble la face principale 3 du substrat donneur 2 avec une face d'un substrat support 6. Le substrat support 6 peut être constitué de tout matériau d'intérêt, par exemple du silicium, du saphir ou du verre.

L'étape d'assemblage du substrat donneur 2 sur le substrat support 6 peut comprendre le collage direct par adhésion moléculaire du substrat donneur 2 sur le substrat support 6. Une couche intermédiaire (non représentée), par exemple en oxyde de silicium peut être formée préalablement à l'assemblage, sur l'une des faces de l'un des substrats 2, 6.

A l'issue de cette étape d'assemblage, on dispose de l'ensemble à fracturer 1 comprenant les deux substrats associés, la face du substrat support 6 adhérant à la face principale 3 du substrat donneur 2.

L'ensemble à fracturer 1, lorsqu'il se trouve dans une position horizontale, présente un plan de fracture 4 défini entre une partie supérieure 7 et une partie inférieure 8, la partie supérieure 7 étant située au-dessus de la partie inférieure 8.

Dans l'exemple représenté sur la figure 2, la partie supérieure 7 comprend le négatif du substrat donneur 2. La partie inférieure 8 comprend quant à elle le substrat support 6 et la couche mince 5 destinée à être transférée. Toutefois, l'invention n'est nullement limitée à une telle configuration, et il est tout à fait envisageable que la partie supérieure 7 comprenne l'assemblage du substrat support 6 et de la couche mince 5 et que la partie inférieure 8 comprenne le négatif du substrat donneur 2.

L'objectif d'un procédé de type Smart Cut^{™} est de réaliser un transfert de la couche mince 5 du substrat donneur 2 sur le substrat support 6. Comme cela a déjà été indiqué, un tel transfert s'effectue traditionnellement après une étape de traitement thermique permettant de fragiliser le plan de fracture 4, puis une étape d'initiation de la séparation, thermique ou mécanique, pour propager une onde de fracture et provoquer la séparation entre les deux parties 7,8 de l'ensemble à fracturer 1. Par séparation, on désigne dans le cadre de la présente demande, le détachement de l'ensemble à fracturer au niveau du plan de fracture conduisant à former les deux parties 7,8.

La figure 3A représente un dispositif de maintien 100 conforme à la présente invention. Un repère Oxyz orthogonal y est représenté, de telle sorte que le plan Oxy soit horizontal. Le dispositif de maintien 100 comprend au moins deux ergots 9 configurés pour maintenir l'ensemble à fracturer 1 en suspension dans une position de maintien sensiblement horizontale.

Dans la présente description, l'expression « en suspension » signifie que la face de la partie inférieure 8 opposée au plan de fracture 4 n'est en contact avec aucun support, avant séparation, lorsque l'ensemble à fracturer 1 se trouve en position de maintien.

L'expression « sensiblement horizontale » signifie que l'ensemble à fracturer 1 se trouve dans une position horizontale, c'est-à-dire parallèle au plan Oxy, avec une inclinaison par rapport à un plan horizontal inférieure ou égale à plus ou moins 10°, et préférentiellement inférieure ou égale à plus ou moins 5°.

La figure 3A représente l'ensemble à fracturer 1 lorsqu'il se trouve en position de maintien, avant séparation. Dans une telle position de maintien, les ergots sont situés entre la partie supérieure 7 et la partie inférieure 8 de l'ensemble à fracturer 1, contre un chanfrein périphérique 10 (également visible sur la figure 2) de la partie supérieure 7.

Classiquement, les substrats étant de forme circulaire avec un diamètre de 200mm ou 300mm par exemple, le chanfrein périphérique 10 de la partie supérieure 7, et un chanfrein 11 de la partie inférieure 8 s'il existe, forment une gorge circulaire en périphérie de l'ensemble à fracturer 1.

Chaque ergot 9 présente une extrémité 12 configurée pour s'insérer dans la gorge. L'extrémité 12 doit être suffisamment fine pour pouvoir être introduite suffisamment profondément dans la gorge de manière à maintenir de façon fiable l'ensemble à fracturer 1 en position de maintien.

Avantageusement, la forme d'un ergot 9 est un biseau dont l'épaisseur suivant la direction (Oz) se réduit dans la direction (Oy) d'une base 13 jusqu'à l'extrémité 12.

Typiquement, la profondeur d'une gorge selon la direction (Oy) est d'environ 250 µm, tandis que l'écart selon la direction (Oz) entre la partie supérieure 7 et la partie inférieure 8 au niveau du pourtour de la gorge est d'environ 300 µm. Afin d'assurer un maintien fiable de l'ensemble à fracturer 1 en position de maintien, l'épaisseur de l'extrémité 12 est alors préférentiellement inférieure à 1 mm, par exemple de 200 µm. L'angle formé par le biseau peut être approximativement de 20°.

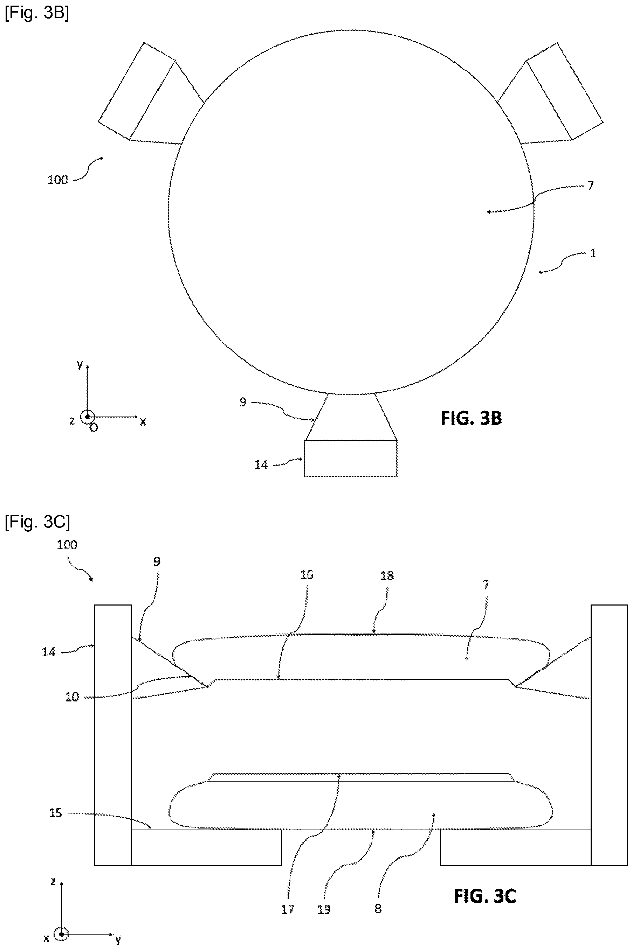

Afin de s'insérer au mieux dans la gorge, l'extrémité 12 peut présenter une forme dans le plan Oxy complémentaire à celle de la gorge. Par exemple, si la gorge est circulaire, l'extrémité 12 peut présenter une géométrie circulaire concave dont le rayon de courbure est semblable à celui de la gorge (figure 3B).

Bien entendu, l'invention n'est nullement limitée aux formes de substrats et d'ergots décrites précédemment. Par exemple, il est possible que les substrats, et donc la gorge, aient une forme polygonale, par exemple rectangulaire, auquel cas l'extrémité 12 peut présenter une géométrie rectiligne dans le plan Oxy. Il est également possible que l'ergot 9 ait une épaisseur suivant la direction (Oz) uniforme, préférentiellement inférieure à 1 mm, par exemple égale à 200 µm.

Les ergots 9 sont disposés au niveau de leur base 13 sur des éléments de soutien 14 permettant de les maintenir à une hauteur déterminée et dans une position angulaire en périphérie de l'ensemble à fracturer 1. Avantageusement, les éléments de soutien 14 peuvent être des colonnes. Une telle configuration permet de faciliter la manipulation de l'ensemble à fracturer 1 (avant séparation) et des deux parties 7,8 (après séparation) entre les ergots 9 par rapport à l'hypothèse où les ergots 9 seraient disposés sur des parois entourant le dispositif, notamment pour l'utilisation de bras articulés.

Quelle que soit la nature des éléments de soutien 14 sur lesquels sont disposés les ergots 9, les éléments de soutien 14 et les ergots 9 sont formés d'un matériau présentant un niveau de propreté compatible avec les exigences classiquement requises dans les procédés de séparation tel que le procédé Smart Cut^{™} afin d'éviter les contaminations. Par exemple, ces matériaux peuvent être choisis parmi le quartz, le carbure de silicium, le silicium, ou certains polymères tels que le Kapton^{®}.

De manière particulièrement avantageuse, au moins un ergot 9 est mobile, afin de pouvoir s'effacer lors de la mise en place de l'ensemble à fracturer. A cet effet, cet ergot 9 peut être rendu solidaire d'une colonne amovible. Lors de la mise en place de l'ensemble à fracturer 1 sur le dispositif de maintien 100, l'ensemble à fracturer 1 est positionné pour engager la gorge périphérique dans les autres ergots 9, par exemple par l'intermédiaire d'un bras articulé, pour placer le chanfrein périphérique 10 sur lesdits ergots 9. Ensuite, la colonne amovible peut être déplacée jusqu'à ce que l'ergot mobile 9 soit mis en butée contre le chanfrein périphérique 10, puis figée dans cette position, plaçant l'ensemble à fracturer 1 dans la position de maintien.

Selon une première variante, la dimension de l'extrémité 12 d'un ergot 9 dans le plan Oxy peut être une fraction du périmètre du chanfrein périphérique 10.

Par exemple, la dimension de l'extrémité 12 pourra être de l'ordre d'un quart, d'un tiers, ou en encore de la moitié du périmètre du chanfrein périphérique 10. En général, dans cette première variante, deux ergots 9 seront suffisants pour maintenir l'ensemble à fracturer 1 dans sa position de maintien notamment lorsqu'ils sont disposés en vis-à-vis l'un de l'autre.

Selon une deuxième variante, particulièrement avantageuse, la dimension de l'extrémité 12 d'un ergot 9 dans le plan Oxy est négligeable devant le périmètre du chanfrein périphérique 10.

L'expression « négligeable » signifie dans la présente description que la dimension de l'extrémité 12 est inférieure au quart du périmètre du chanfrein périphérique 10, voire inférieure à un dixième du périmètre du chanfrein périphérique 10.

Typiquement, la dimension de l'extrémité 12 dans le plan Oxy peut être de 10 mm.

Une telle configuration permet de disposer les ergots 9 sur des colonnes 14 de faible largeur, afin de diminuer leur encombrement et faciliter les manipulations.

Dans cette variante illustrée sur la figure 3B, le dispositif de maintien 100 comprend au moins trois ergots 9. Cela permet à l'ensemble à fracturer 1 de conserver une stabilité dans sa position de maintien malgré la faible dimension des ergots 9. Par exemple, le dispositif de maintien 100 peut comprendre trois, quatre, cinq voire six ergots 9 pour maintenir l'ensemble à fracturer 1.

Dans les situations où le dispositif de maintien 100 comprend plus de quatre ergots 9, il est souhaitable qu'au moins deux ergots 9 soient mobiles, disposés sur des colonnes amovibles, afin de faciliter la manipulation et le placement de l'ensemble à fracturer 1 en position de maintien.

Préférentiellement, pour assurer une meilleure stabilité, les ergots 9 sont positionnés angulairement de manière régulière autour de l'ensemble à fracturer 1. Par exemple, lorsque le chanfrein périphérique 10 présente une forme circulaire, les ergots 9 sont uniformément répartis autour de l'ensemble à fracturer 1, comme cela est représenté sur la figure 3B. Toutefois, l'invention n'est nullement limitée à une telle répartition.

Comme cela a déjà été évoqué, l'ensemble à fracturer 1 est destiné à se séparer le long du plan de fracture 4 pour former la partie supérieure 7 et la partie inférieure 8. Une illustration d'un dispositif de maintien 100 après séparation de l'ensemble à fracturer 1 est représenté sur la figure 3C. La partie supérieure 7 comprend une face avant 16 issue de la séparation au niveau du plan de fracture 4 de l'ensemble à fracturer 1, en regard d'une face avant 17 de la partie inférieure 8. La partie supérieure 7 comprend également une face arrière 18 opposée à sa face avant 16. La partie inférieure 8 comprend de la même façon une face arrière 19 opposée à sa face avant 17.

Le dispositif de maintien 100 conforme à la présente invention comprend un support 15, situé en dessous et à distance des ergots 9.

L'expression « en dessous » signifie dans le cadre de la présente description qu'en utilisation avec l'ensemble à fracturer 1, le support 15 est positionné par rapport aux ergots 9 de manière à recevoir, lorsque l'ensemble à fracturer 1 est séparé, la partie inférieure 8 par gravité. Pour le dire autrement, au moment de la séparation de l'ensemble à fracturer 1, la partie supérieure 7 et la partie inférieure 8 se séparent au niveau du plan de fracture 4 : la partie supérieure 7 demeure maintenue par les ergots 9, tandis que la partie inférieure 8 est entraînée par gravité jusqu'à ce que sa face arrière 19 soit en contact avec le support 15.

Par l'expression « à distance », on entend que la distance entre le support 15 et les ergots 9 est strictement supérieure à l'épaisseur de la partie inférieure 8, de telle sorte qu'en position de maintien, l'ensemble à fracturer 1 ne soit pas en contact avec le support 15. La zone de contact entre l'ensemble à fracturer 1 et le dispositif de maintien 100 est ainsi limitée aux ergots 9. Le maintien de l'ensemble à fracturer 1 par les seuls ergots 9 permet de minimiser les contraintes qui s'appliquent sur lui. La minimisation de la surface de contact entre l'ensemble à fracturer 1 et le dispositif de maintien 100 permet, lors de la fracture, de laisser chaque partie 7,8 de l'ensemble à fracturer 1 libre de se déformer. Tout contact avec la face arrière 19 de la partie inférieure 8 formant une empreinte sur sa face avant 17 au moment de la fracture, la minimisation de ces contacts favorise une propagation homogène de l'onde de fracture.

L'expression « à distance » signifie également que lorsque l'ensemble à fracturer 1 est séparé, la distance entre le support 15 et les ergots 9 est suffisante pour permettre à la partie inférieure 8 de se séparer effectivement de la partie supérieure 7 maintenue par les ergots 9, et de maintenir les deux parties à distance l'une de l'autre, c'est-à-dire sans contact entre leurs faces avant 16, 17.

Avantageusement, la distance entre le support 15 et les ergots 9 est suffisante pour permettre de manipuler et d'extraire l'une ou l'autre des parties 7,8 sans risquer de provoquer de contact entre elles.

La distance entre les ergots 9 et le support 15 est choisie entre 1,5 et 10 mm, voire entre 2 mm et 5 mm, pour une partie inférieure 8 présentant une épaisseur dans la direction (Oz) comprise entre 500 microns et 800 microns.

Le support 15 peut être d'un seul tenant, et relié à une partie au moins des éléments de soutien 14. Par exemple, il peut s'agir d'un plateau solidairement conçu avec les éléments de soutien 14, par exemple circulaire et préférentiellement constitué des mêmes matériaux qu'eux.

Selon une configuration particulièrement avantageuse, le support 15 comprend un évidement pour permettre la préhension de la partie inférieure 8 par sa face arrière 19, par exemple par le bras articulé d'un robot automatisé. Une telle configuration évite toute intervention dans la zone située entre les deux faces avant 16, 17, susceptible d'endommager ou de contaminer l'une ou l'autre des parties 7,8.

Alternativement, le dispositif de maintien 100 peut comprendre une pluralité de supports 15, chaque support étant indépendamment relié à un élément de soutien 14, de telle sorte que les faces de la pluralité de supports 15 en regard des ergots 9 soient parallèles et à la même hauteur, de manière à maintenir la partie inférieure 8 après séparation dans une position sensiblement horizontale. Par exemple, si les éléments de soutien comprennent des colonnes 14, un support 15 peut être un pied de la colonne 14, s'étendant dans la même direction que l'ergot 9, en dessous de celui-ci.

Dans ce mode de réalisation particulier, la partie inférieure 8 est entraînée par gravité jusqu'à ce que sa face arrière 19 entre en contact avec la pluralité de supports 15.

La forme du support 15 est indifférente, par exemple rectangulaire. Préférentiellement, sa forme est adaptée pour être la moins encombrante possible et ne pas gêner la manipulation de la partie inférieure 8.

De même, les dimensions du support 15 sont indifférentes, et pourront être choisies en fonction des dimensions de l'ensemble à fracturer 1 de manière à limiter l'encombrement, permettre la préhension de la partie inférieure 8 par sa face arrière 19, et être suffisamment solide pour soutenir les éléments de soutien 14 et l'ensemble à fracturer 1.

En tout état de cause, pour permettre une manipulation confortable, la distance entre les deux parties 7,8 issues de l'élément à fracturer 1 après séparation est préférentiellement supérieure à 1 mm.

Toutefois, cette distance ne doit pas être trop importante pour ne pas risquer un endommagement de la partie inférieure 8 à la fin de sa chute lors de son entrée en contact avec le support 15.

La Demanderesse a constaté en particulier qu'il existait une distance maximale, de l'ordre de 5 mm, qu'il était particulièrement avantageux de ne pas dépasser pour profiter d'un effet physique permettant de diminuer la vitesse de la partie inférieure 8 au cours de sa chute après séparation de l'ensemble à fracturer 1.

A la séparation des deux parties 7,8 au niveau du plan de fracture 4, la partie inférieure 8 est attirée vers le support 15 sous l'effet de la gravité. La pression dans l'espace situé entre la face arrière 19 de la partie inférieure 8 et le support 15 est alors proche de la pression atmosphérique, plus faible que la pression dans l'espace situé entre les deux parties 7,8 du fait de la pression des espèces gazeuses dans les cavités formant le plan de fracture 4. Cette différence de pression favorise également l'écartement des deux parties 7,8.

Toutefois, l'écartement soudain des deux parties 7,8 conduit à une sous-pression dans l'espace situé entre lesdites parties 7,8, laquelle sous-pression ralentit la chute de la partie inférieure 8, la pression au-dessus de la partie inférieure 8 étant inférieure à la pression en-dessous.

Le faible espacement séparant les deux parties 7,8 combiné à la viscosité de l'air, limite la circulation de l'air entre ces deux parties, 7, 8 et le rééquilibrage des pressions, ce qui contribue à ralentir la chute de la partie inférieure 8 jusqu'à son entrée en contact avec le support 15. On diminue ainsi les risques d'endommagement de la face arrière 19 de la partie inférieure 8.

Par conséquent, la distance entre les deux faces avant 16, 17 lorsque la face arrière 19 de la partie inférieure 8 est en contact avec le support 15 est préférentiellement comprise entre 1 et 5 mm, pour conserver les effets précités qui favorisent un atterrissage contrôlé de la partie inférieure 8 sur le support 15.

Dans le cas où la partie inférieure 8 est un substrat SOI, son épaisseur est typiquement de l'ordre de 700 à 800 micromètres, pour un diamètre de 200 ou 300 mm.

Avantageusement, et de manière non limitative, un dispositif de maintien 100 conforme à la présente invention peut être utilisé dans le cadre d'un équipement de séparation pour séparer l'ensemble à fracturer 1.

Le dispositif de maintien 100 peut être disposé dans une enceinte, par exemple la chambre d'un four apte à réaliser un traitement thermique de l'ensemble à fracturer 1, dans une gamme de température de 100 à 500°C par exemple.

Les moyens de chauffage du four pourront être des moyens de chauffage par convection, par rayonnement infrarouge ou micro-ondes, ou par induction.

Un tel traitement thermique, bien connu en soi, permet de fragiliser le plan de fracture 4 en favorisant la coalescence et la mise sous pression des microcavités contenues dans le plan de fracture 4.

Préférentiellement, le dispositif de maintien 100 est disposé dans un four monoplaque à recuit rapide, afin de pouvoir porter l'ensemble à fracturer 1 à la température de fragilisation et/ou de fracture dans un temps très court, typiquement quelques secondes à quelques minutes. Une telle rapidité permet une séparation rapide d'un ensemble à fracturer 1, rendant possible une cadence importante de l'équipement de séparation.

Dans l'hypothèse où le dispositif de maintien 100 est inclus dans un équipement de séparation et que le dispositif de maintien 100 est susceptible d'être placé dans un four, le matériau constituant les éléments de soutien 14 et les ergots 9 doit, en plus de respecter les conditions liées à la contamination des parties supérieure 7 et inférieure 8 de l'élément à fracturer 1, présenter des propriétés de résistance thermique pour les températures précédemment évoquées. En particulier, parmi la liste décrite précédemment, les matériaux composant les éléments de soutien 14 et les ergots 9 sont alors préférentiellement choisis parmi le quartz, le carbure de silicium, le silicium ou le Kapton.

Alternativement, un dispositif de maintien 100 conforme à l'invention peut être disposé non pas dans le four, mais à la sortie du four, pour recueillir l'ensemble à fracturer 1 une fois une étape de fragilisation réalisée et avant que la fracture ne se soit produite.

Un dispositif de maintien 100 conforme à l'invention peut également être entièrement distinct d'un four, la fragilisation de l'ensemble à fracturer 1 étant alors réalisée en amont, indépendamment du dispositif de maintien 100.

Avantageusement, l'enceinte dans laquelle peut être placé un dispositif de maintien 100 conforme à l'invention peut comprendre des moyens pour maintenir une atmosphère contrôlée, et de préférence non oxydante, pendant une partie au moins du traitement. La Demanderesse a remarqué qu'une telle atmosphère non oxydante permettait de procéder, lorsqu'elle était appliquée en température à partir au moins de l'instant de détachement des deux parties, à un lissage des deux faces avant 16, 17 à une température moindre que dans le cas d'une atmosphère contenant une quantité notable d'oxygène.

Par « non oxydante », on entend typiquement une atmosphère présentant une teneur en oxygène, pouvant être contenu dans du dioxygène ou dans de l'eau notamment, inférieure à 10 ppm. L'atmosphère contrôlée peut ainsi être une atmosphère neutre ou réductrice. L'atmosphère non oxydante à l'intérieur de l'enceinte peut être obtenue par des moyens de circulation d'un flux gazeux continu de gaz inerte (tel que de l'argon ou de l'hélium) ou de gaz réducteur (tel que de l'hydrogène).

Les effets d'une telle étape de lissage en atmosphère non oxydante ont été décrits plus en détail dans le document FR 3 061 988.

Selon une variante de l'invention, le dispositif de maintien 100 peut comprendre des moyens d'initiation d'une onde de fracture dans le plan de fracture 4 de l'ensemble à fracturer 1.

Selon une première option, les moyens d'initiation sont formés par un élément d'ouverture mécanique, comprenant par exemple une lame. La lame peut être disposée sur l'une des colonnes amovibles en complément ou en remplacement de l'un des ergots 9. Avec le déplacement de la colonne 14, la lame peut être insérée entre les deux parties 7,8, exerçant ainsi un contrainte mécanique apte à initier la propagation de l'onde de fracture le long du plan de fracture 4. Alternativement, la lame peut être fixée à un bras articulé, dont le mouvement peut être commandé indépendamment des colonnes 14 supportant les ergots 9.

La lame est réalisée dans un matériau lisse, assez dur pour pénétrer l'ensemble à fracturer 1 mais pas trop dur afin de ne pas risquer d'endommager les faces avant 16, 17 des parties 7,8. A titre d'exemple, la lame peut être réalisée dans un matériau tel que le polychlorure de vinyle (PVC) ou le polyetheretherketone (PEEK).

Selon une deuxième option, les moyens d'initiation comprennent un appareil à ultrasons apte à émettre une onde ultrasonore. L'onde ultrasonore, dirigée en direction du plan de fracture 4, se propage à l'intérieur des microcavités du plan de fracture 4 fragilisé, permettant l'initiation de la propagation de l'onde de fracture.

On pourra bien-sûr envisager d'autres options pour les moyens d'initiation.

L'initiation mécanique de l'onde de fracture, selon l'une quelconque des options précitées, peut être réalisée à l'intérieur ou à l'extérieur du four.

A la suite de l'initiation, l'onde de fracture s'auto-propage dans le plan de fracture 4, conduisant à la séparation de l'ensemble à fracturer 1, en deux partie 7,8 comme décrit précédemment et illustré sur la figure 3C.

Bien entendu, l'invention n'est pas limitée aux modes de mise en oeuvre décrits et l'on peut y apporter des variantes de réalisation sans sortir du cadre de l'invention tel que défini par les revendications.

Ainsi, bien que l'on ait présenté un équipement de séparation permettant de séparer un ensemble à fracturer à pression atmosphérique, il est possible de prévoir des moyens permettant de contrôler la pression de l'atmosphère régnant autour des parties 7, 8 pendant le traitement ou à partir de l'instant de séparation, lorsque celui-ci se déroule dans une enceinte.

Ainsi, une diminution de la pression de l'enceinte conduit à diminuer la différence de pression existant dans les instants suivant le moment du détachement entre l'espace situé entre les deux parties 7, 8 et le reste du volume de l'enceinte. Le phénomène de ralentissement de la chute de la partie inférieure 8 est alors atténué. Un tel contrôle peut être intéressant en ce qu'il permet d'accélérer l'éloignement des parties inférieure 8 et supérieure 7 l'une de l'autre. La vitesse d'éloignement peut à l'inverse être diminuée par une augmentation contrôlée de la pression régnant dans l'enceinte.

## Revendications

1. Dispositif de maintien (100) d'un ensemble à fracturer (1) destiné à se séparer le long d'un plan de fracture (4) défini entre une partie supérieure (7) et une partie inférieure (8) de l'ensemble à fracturer (1), le dispositif de maintien (100) comprenant :
- au moins deux ergots (9) configurés pour maintenir l'ensemble à fracturer (1) en suspension dans une position de maintien sensiblement horizontale, les ergots (9) étant destinés à être situés entre la partie supérieure (7) et la partie inférieure (8), contre un chanfrein périphérique (10) de la partie supérieure (7) ;
- un support (15), situé en dessous et à distance des ergots (9), de manière à recevoir la partie inférieure (8) par gravité, lorsque l'ensemble à fracturer (1) est séparé, et à la maintenir à distance de la partie supérieure (7) maintenue par les ergots (9), la distance entre le support (15) et les ergots (9) étant comprise entre 1,5 et 10 mm, préférentiellement entre 2 et 5 mm.

2. Dispositif de maintien (100) selon l'une des revendications précédentes dans lequel les ergots (9) sont disposés sur des colonnes (14).

3. Dispositif de maintien (100) selon l'une des revendications précédentes dans lequel au moins un ergot (9) est disposé sur une colonne amovible apte à être déplacée pour placer l'ensemble à fracturer (1) dans la position de maintien.

4. Dispositif de maintien (100) selon l'une des revendications précédentes comprenant au moins trois ergots (9).

5. Dispositif de maintien (100) selon l'une des revendications précédentes comprenant également des moyens d'initiation d'une onde de fracture pour initier, dans le plan de fracture (4), la séparation de l'ensemble à fracturer (1).

6. Dispositif de maintien (100) selon l'une des revendications précédentes dans lequel les moyens d'initiation comprennent une lame.

7. Dispositif de maintien (100) selon l'une des revendications précédentes dans lequel les moyens d'initiation comprennent un appareil à ultrasons apte à émettre une onde ultrasonore.

8. Dispositif de maintien (100) selon l'une des revendications précédentes dans laquelle le support (15) est destiné à recevoir la partie inférieure (8) au niveau d'une face arrière (19) de la partie inférieure (8) et comprend un évidement pour permettre la préhension de la partie inférieure (8) par sa face arrière (19).

9. Équipement de séparation pour séparer un ensemble à fracturer (1), l'équipement de séparation comprenant une enceinte et, disposé dans l'enceinte, un dispositif de maintien (100) conforme à l'une des revendications 1 à 8.

10. Équipement de séparation selon la revendication précédente dans lequel l'enceinte est une chambre d'un four pour réaliser un traitement thermique de l'ensemble à fracturer (1) et pour fragiliser le plan de fracture (4).

11. Équipement de séparation selon la revendication précédente dans lequel le four comprend des moyens de chauffage par convection, par rayonnement IR ou micro-ondes, par induction.

12. Équipement de séparation selon la revendication précédente dans lequel le four est un four monoplaque à recuit rapide.

## Patentansprüche

1. Haltevorrichtung (100) für eine zu zerbrechende Anordnung (1), die dazu bestimmt ist, sich entlang einer zwischen einem oberen Teil (7) und einem unteren Teil (8) der zu zerbrechenden Anordnung (1) definierten Bruchebene (4) zu teilen, die Haltevorrichtung (100) umfassend:
- mindestens zwei Nasen (9), die konfiguriert sind, um die zu zerbrechende Anordnung (1) in einer im Wesentlichen horizontalen Halteposition schwebend zu halten, wobei die Nasen (9) dazu bestimmt sind, zwischen dem oberen Teil (7) und dem unteren Teil (8) an einer Umfangsschräge (10) des oberen Teils (7) gelegen zu sein;
- einen Ständer (15), der derart unterhalb und von den Nasen (9) beabstandet gelegen ist, dass er durch Schwerkraftwirkung den unteren Teil (8) aufnimmt, wenn die zu zerbrechende Anordnung (1) getrennt ist, und ihn in einem Abstand von dem oberen Teil (7) hält, der durch die Nasen (9) gehalten wird, wobei der Abstand zwischen dem Ständer (15) und den Nasen (9) zwischen 1,5 und 10 mm, vorzugsweise zwischen 2 und 5 mm, beträgt.

2. Haltevorrichtung (100) nach einem der vorstehenden Ansprüche, wobei die Nasen (9) an Säulen (14) eingerichtet sind.

3. Haltevorrichtung (100) nach einem der vorstehenden Ansprüche, wobei mindestens eine Nase (9) an einer wegnehmbaren Säule eingerichtet ist, die geeignet ist, um zum Platzieren der zu zerbrechenden Anordnung (1) in der Halteposition bewegt zu werden.

4. Haltevorrichtung (100) nach einem der vorstehenden Ansprüche, umfassend mindestens drei Nasen (9).

5. Haltevorrichtung (100) nach einem der vorstehenden Ansprüche, ferner umfassend Mittel zum Auslösen einer Bruchwelle zum Auslösen in der Bruchebene (4) der Trennung der zu zerbrechenden Anordnung (1).

6. Haltevorrichtung (100) nach einem der vorstehenden Ansprüche, wobei die Auslösemittel eine Klinge umfassen.

7. Haltevorrichtung (100) nach einem der vorstehenden Ansprüche, wobei die Auslösemittel eine Ultraschalleinrichtung umfassen, die geeignet ist, um eine Ultraschallwelle zu emittieren.

8. Haltevorrichtung (100) nach einem der vorstehenden Ansprüche, wobei der Ständer (15) zum Aufnehmen des unteren Teils (8) an einer Rückseite (19) des unteren Teils (8) bestimmt ist und eine Aussparung umfasst, um das Ergreifen des unteren Teils (8) an seiner Rückseite (19) zu ermöglichen.

9. Trenngerät zum Trennen einer zu zerbrechenden Anordnung (1), wobei das Trenngerät ein Gehäuse umfasst und in dem Gehäuse eine Haltevorrichtung (100) nach einem der Ansprüche 1 bis 8 eingerichtet ist.

10. Trenngerät nach dem vorstehenden Anspruch, wobei das Gehäuse eine Kammer eines Ofens zum Durchführen einer Wärmebehandlung der zu zerbrechenden Anordnung (1) und zum Verspröden der Bruchebene (4) ist.

11. Trenngerät nach dem vorstehenden Anspruch, wobei der Ofen Heizmittel durch Konvektion, durch IR-Strahlung oder Mikrowellen, durch Induktion umfasst.

12. Trenngerät nach dem vorstehenden Anspruch, wobei der Ofen ein Schnellglühofen mit einer Platte ist.

## Claims

1. Device (100) for holding an assembly to be fractured (1), the assembly being intended to separate along a fracture plane (4) defined between an upper part (7) and a lower part (8) of the assembly to be fractured (1), the holding device (100) comprising:
- at least two lugs (9) designed to hold the assembly to be fractured (1) in suspension in a substantially horizontal holding position, the lugs (9) being intended to be located between the upper part (7) and the lower part (8) and against a peripheral chamfer (10) of the upper part (7);
- a support (15), located below and at a distance from the lugs (9) so as to receive the lower part (8) by gravity when the assembly to be fractured (1) is separated, and to hold said lower part at a distance from the upper part (7) held by the lugs (9), the distance between the support (15) and the lugs (9) being between 1.5 and 10 mm, preferably between 2 and 5 mm.

2. Holding device (100) according to any of the preceding claims, wherein the lugs (9) are arranged on columns (14).

3. Holding device (100) according to either of the preceding claims, wherein at least one lug (9) is arranged on a removable column, which is capable of being displaced in order to place the assembly to be fractured (1) in the holding position.

4. Holding device (100) according to any of the preceding claims, the device comprising at least three lugs (9).

5. Holding device (100) according to any of the preceding claims, further comprising means for initiating a fracture wave in order to initiate, in the fracture plane (4), the separation of the assembly to be fractured (1).

6. Holding device (100) according to any of the preceding claims, wherein the initiation means comprise a blade.

7. Holding device (100) according to any of the preceding claims, wherein the initiation means comprise an ultrasound apparatus capable of emitting an ultrasonic wave.

8. Holding device (100) according to any of the preceding claims, wherein the support (15) is intended to receive the lower part (8) at a rear face (19) of the lower part (8) and comprises a recess to allow gripping of the lower part (8) via its rear face (19).

9. Separation equipment for separating an assembly to be fractured (1), the separation equipment comprising an enclosed space and, arranged in the enclosed space, a holding device (100) according to any of claims 1 to 8.

10. Separation equipment according to the preceding claim, wherein the enclosed space is a chamber of an oven for carrying out a heat treatment on the assembly to be fractured (1) and for weakening the fracture plane (4).

11. Separation equipment according to the preceding claim, wherein the oven comprises means for heating by convection, by IR radiation or by microwave radiation, or by induction.

12. Separation equipment according to the preceding claim, wherein the oven is a single-wafer rapid-annealing oven.
